# EUROPEAN PATENT APPLICATION

(11) **EP 4 773 745 A1**
(43) Date of publication of application: **08.07.2026**
(21) Application number: 25216429.8
(22) Date of filing: 17.11.2025
(51) Int. Cl.: H05K 7/20

(54) **ORTHOGONAL COLD PLATE FOR USE IN ACTIVE LIQUID IMMERSION COOLING**

(30) Priority: 20.12.2024 US 202418989533
(71) Applicant: Intel Corporation, Santa Clara, CA 95054 (US)
(72) Inventor: AMOAH-KUSI, Christian, Scappoose, 97056 (US); CHUANG, Chi-Hung, 242 New Taipei City (TW); HE, Jing-Hua, Portland, 97229 (US)
(74) Representative: Maiwald GmbH

(57) **Abstract**

A cold plate comprises a plurality of fins. The individual fins have an opening, and the openings collectively define a first channel through the plurality of fins. During operation of an integrated circuit component attached to the cold plate, coolant is pumped through the cold plate. The coolant flows in a first direction through the first channel and then in a second through second channels located between the fins. The first direction is substantially orthogonal to the second direction. The first channel can comprise a tube that has openings that direct coolant to flow into the second channels. The first channel is located close to the base plate of the cold plate so that there is a high degree of heat transfer between an integrated circuit component attached to the cold plate and coolant flowing through the cold plate.

## Description

### BACKGROUND

In liquid immersion cooling, computing components are submerged in a thermally conductive dielectric liquid. Heat generated by the computing components is absorbed by the dielectric liquid and then dissipated into the environment by, for example, the dielectric liquid circulating through a heat exchanger.

### BRIEF DESCRIPTION OF THE DRAWINGS

FIG. 1A is a perspective view of a first impinging cold plate assembly.
FIG. 1B is a cross-sectional view of the cold plate assembly illustrated in FIG. 1A along line A-A'.
FIG. 1C is a perspective cross-sectional view of a variation of the cold plate assembly illustrated in FIG. 1A along line A-A'.
FIG. 2 is a perspective view of a second impinging cold plate assembly.
FIG. 3 is a cross-sectional top view of the impinging cold plate assembly of FIG. 2 taken along line B-B'.
FIG. 4 is a perspective view of a first example orthogonal cold plate assembly.
FIG. 5 is a cross-sectional perspective view of the cold plate assembly illustrated in FIG. 4 taken along line C-C'.
FIG. 6 is a cross-sectional view of the cold plate assembly illustrated in FIG. 4 taken along line D-D'.
FIG. 7 is a perspective cross-sectional view of the cold plate assembly illustrated in FIG. 4 taken along lines C-C' and D-D'.
FIG. 8 is a cross-sectional view of the cold plate assembly illustrated in FIG. 4 taken along line E-E'.
FIG. 9 is a top-down cross-sectional view of the cold plate assembly illustrated in FIG. 4 taken along line C-C'.
FIG. 10 is a perspective view of a second example orthogonal cold plate assembly.
FIG. 11 is a cross-sectional perspective view of the cold plate assembly illustrated in FIG. 10 taken along line F-F'.
FIG. 12 is a cross-sectional view of the cold plate assembly illustrated in FIG. 10 taken along line G-G'.
FIG. 13 is a perspective cross-sectional view of the cold plate assembly illustrated in FIG. 10 taken along lines F-F' and G-G'.
FIG. 14 is a perspective cross-sectional view of the cold plate assembly illustrated in FIG. 10 taken along lines H-H'.
FIG. 15 is a perspective cross-sectional view of a variation of the cold plate assembly illustrated in FIG. 10 taken along lines F-F'.
FIG. 16 is an example method of cooling an integrated circuit component via a thermal management solution utilizing a cold plate assembly in accordance with any of the embodiments disclosed herein.
FIG. 17 is a cross-sectional view of an integrated circuit die that may be included in any of the integrated circuit components disclosed herein.
FIG. 18 is a cross-sectional side view of an integrated circuit device assembly that may include any of the cold plate assemblies disclosed herein.
FIG. 19 is a block diagram of an example electrical device that is to be subjected to active liquid immersion cooling and that may include one or more of the integrated circuit assemblies disclosed herein.

### DETAILED DESCRIPTION

As the power consumption of high-performance central processing units (CPUs) continues to increase generation over generation, it may be difficult to cool such CPUs with air-based thermal management solutions. Passive single-phase liquid immersion cooling solutions with per- or polyfluoroalkyl (PFAS) fluids as the immersion coolant are an option, but an upcoming European Union ban on these chemicals has led many liquid immersion fluid users to exclusively rely on hydrocarbons as the immersion coolant. As a consequence, at least at the 1U form factor, the thermal resistance of passive liquid immersion cold plates may be no better than that of air-cooled passive heat sinks.

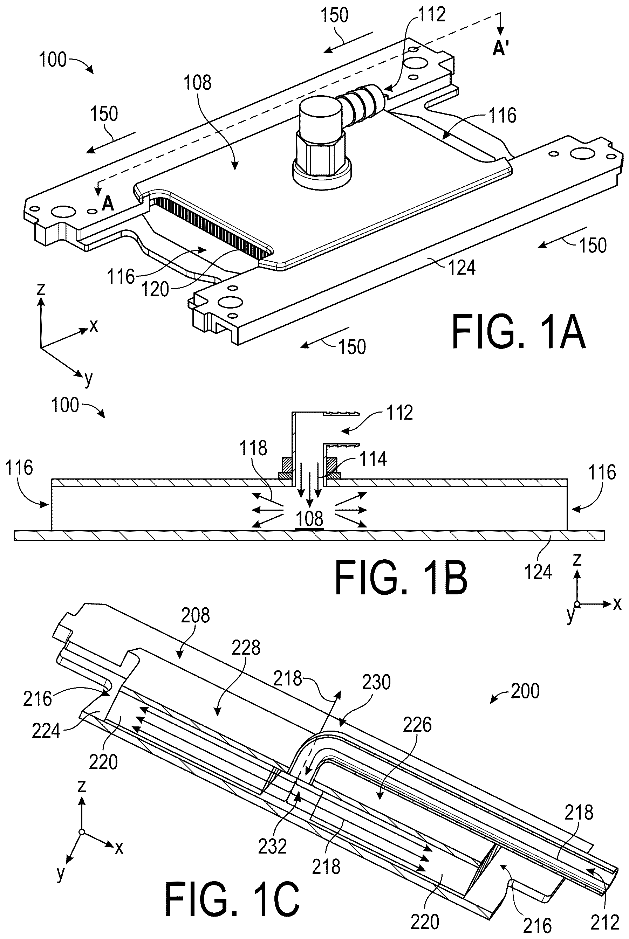

Active immersion cooling, whereby coolant is pumped through a cold plate, has been explored as a thermal management solution for high power-consumption CPUs. FIGS. 1A-1C, 2, and 3 illustrate existing active immersion cold plate assemblies in which coolant entering a cold plate inlet impinges on a base of the cold plate. FIG. 1A is a perspective view of a first impinging cold plate assembly for use in active immersion cooling. FIG. 1B is a cross-sectional view of the cold plate assembly illustrated in FIG. 1A along line A-A'. The cold plate assembly 100 comprises base plate 124, chamber 108, inlet 112, and dual outlets 116. The chamber 108 comprises fins 120 that extend upwards from the base plate 124. During operation, immersion coolant (coolant) flows through the cold plate assembly 100 along a path indicated by arrows 114 and 118. The coolant enters the cold plate assembly 100 via the inlet 112, impinges on the base plate 124, and then passes between the fins 120 before exiting the cold plate assembly 100 through the outlets 116. FIG. 1C is a perspective cross-sectional view of a variation of the cold plate assembly illustrated in FIG. 1A along line A_A'. The cold plate assembly 200 comprises base plate 224, chamber 208, inlet 212, and outlets 216 and 230. The chamber 208 comprises banks 226 and 228 of fins 220 separated by a channel 232 that leads to outlet 230. During operation, coolant flows through the cold plate assembly 200 along a path indicated by arrows 218.

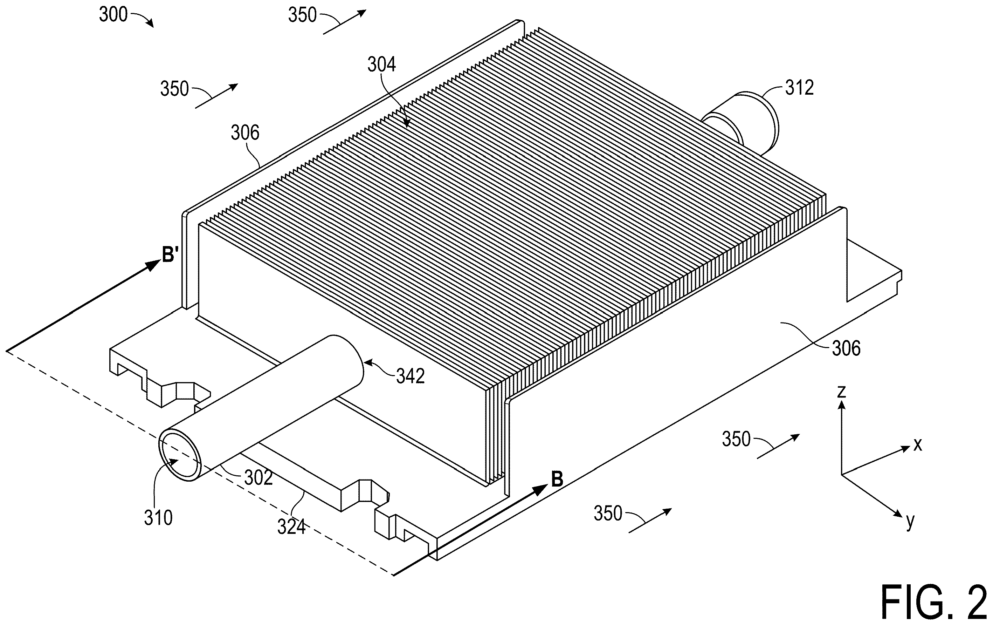

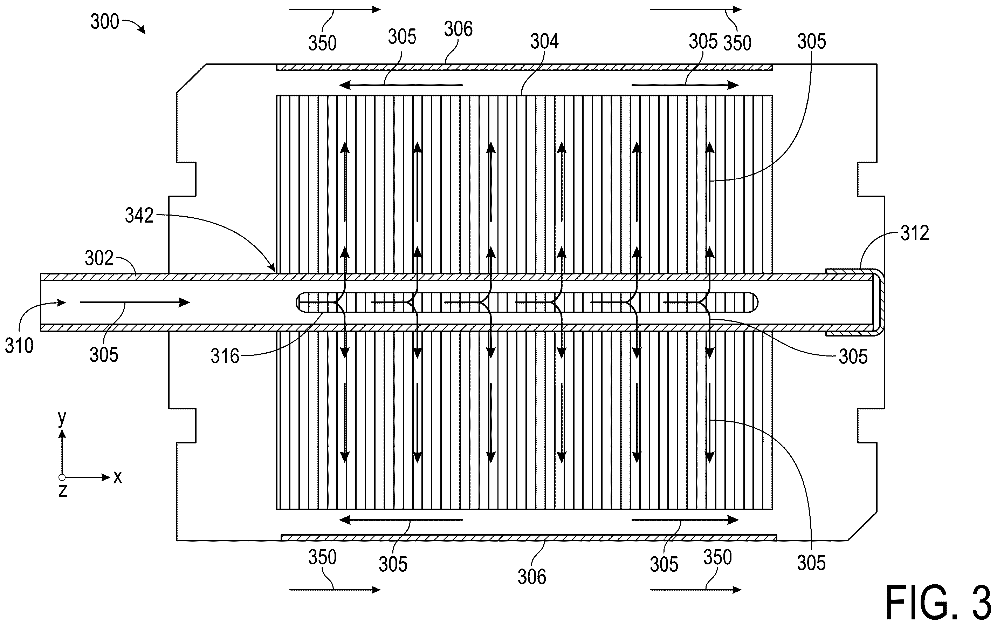

FIG. 2 is a perspective view of a second impinging cold plate assembly for use in active immersion cooling. The cold plate assembly 300 includes a tube 302, fins 304, sidewalls 306, and a base plate 324. The fins 304 and the sidewalls 306 extend upwards from the base plate 324. The tube 302 extends through holes 342 in the fins 304. The tube 302 comprises an inlet 310. The tube 302 receives an immersion coolant and directs the coolant into the cold plate assembly 300. The tube 302 includes a slot 316 (see FIG. 3) that distributes the coolant between the fins 304. The sidewalls 306 direct the flow of coolant exiting the fins 304.

FIG. 3 is a cross-sectional top view of the impinging cold plate assembly of FIG. 3 taken along line B-B'. The tube 302 comprises a slot 316 formed on the tube 302 in the portion of the tube 302 extending through the fins 304. An end 312 of the tube 302 located opposite to the inlet 310 is closed. The inlet 310, the tube 302, the slot 316, the fins 304, and the sidewalls 306 sequentially define an example coolant pathway 305. The slot 316 enables the coolant flowing through the tube 302 to exit the tube 302 and enter channels between the fins 304. The coolant exiting the tube 302 via the slot 316 impinges the base plate 324. The coolant pathway 305, illustrated as thick black lines, defines the flow path of coolant through the assembly 300. The coolant pathway 305 begins at the inlet 310, travels through the tube 302, leaves the tube 302 via the slot 316, and flows through the fins 304. After leaving the fins 304, the coolant pathway 305 extends along the sidewalls 306 and leaves the cold plate assembly 300.

In both cold plate assemblies 100 and 200, half of the coolant exiting the assemblies opposes the bulk flow of coolant in the immersion tank within which the assemblies are located, indicated by arrows 150 in FIGS. 1A and arrows 350 in FIGS. 2 and 3.

Described herein are orthogonal cold plates for use in active immersion cooling that can have a thermal resistance as good as or better than air-cooled heat sinks and a low pressure drop. The cold plates are "orthogonal" in that coolant pumped into any of the cold plates described herein first flows through a channel extending in a first direction defined by openings in a plurality of fins, the channel being parallel to and close to a base plate of the cold plate. The coolant then flows in a second direction between the fins that is substantially orthogonal to the first direction. The channel may contain a tube. In tubed embodiments, the coolant does not exit through an opening in the bottom of the tube to impinge against the base plate of a cold plate. In the cold plates described herein, the coolant takes a single turn as it passes through the cold plate - the turn it takes as it turns from traveling through the channel extending through the fins to traveling through the channels between fins. This single turn can be fewer turns than a coolant may take in the impingement cold plate-based solutions illustrated in FIGS. 1A-1C, 2, and 3.

The cold plate assemblies disclosed herein also have the advantage that there is a high degree of heat transfer between the heat-generated component and the coolant owing to the channel through which the coolant flows after entering the cold plate assembly being close to the surface of the cold plate base plate. Cold plate assemblies in which the coolant enters a cold plate assembly via an inlet located on top of the cold plate assembly (e.g., cold plate assembly 100) have a lower degree of heat transfer between the heat-generating component and the coolant. The thermal resistance of passive immersion cooling thermal management solutions can be in the range of about 0.10-0.13 °C/W at 2-3 LPM of coolant flow through the cold plate, which is equivalent to that of air-cooled heat sinks. In the active orthogonal cold plate-based solutions disclosed herein, the thermal resistance of the thermal management solution can be in the range of 0.022-0.027 °C/W under the same conditions.

Table 1 lists simulated thermal resistances along with integrated circuit component power consumption levels that can be cooled by the list cold plate designs for thermal management solutions based on the "orthogonal" cold plate technologies disclosed herein and the two-impingement cold plate-based solutions illustrated in FIGS. 1A-1C, 2, and 3 and can thus present a lower flow resistance. The simulations were performed assuming polyalphaolefin (POA) coolant and a coolant flow rate of 2 LPM through the cold plate. POA6 was used for the cold plate design illustrated in FIGS. 2-3. POA6 is a higher-performing hydrocarbon than POA4 and thus should be advantageous for the impingement cold plate-based solutions illustrated in FIGS. 2-3. The values shown in Table 1 show that thermal management solutions based on the orthogonal cold plate technologies disclosed herein may have a thermal resistance that is about 26% and 48% less than that of the impingement cold plate-based thermal management solutions illustrated in FIGS. 1A-1C, 2, and 3. The simulation results indicate that orthogonal cold plate assemblies can have a more uniform temperature distribution and fewer hot spots than the impingement cold plate assembly designs of FIGS. 2-3. The simulation results further suggest that this may be due in part a more even coolant flow velocity between the fins, including higher flow velocities toward the base of the fins along the length of the fins in the orthogonal cold plate assembly designs.

**Table 1. Thermal resistance of orthogonal and impingement cold plate-based thermal management solutions.**

| Cold plate design | Thermal resistance (°C/W) | Integrated circuit component power range (W) | Coolant | Improvement |
|---|---|---|---|---|
| Orthogonal | 0.027 | 500-1000 | PAO4 | - |
| FIGS. 1A-1C | 0.034 | 500-1000 | PAO4 | 26% |
| FIGS. 2-3 | 0.040 | 350 | PAO6 | 48% |

In addition to having a reduced thermal resistance, removing impingement of the coolant against the cold plate base plate from the coolant flow and limiting the number of turns the coolant takes while flowing through a cold plate can result in orthogonal cold plates having a lower coolant pressure drop relative to the impingement cold plates illustrated in FIGS. 1A-1C, 2, and 3. Table 2 shows that the simulated coolant pressure drop across a cold plate for the orthogonal cold plate designs disclosed herein is less than that of the cold plate design illustrated in FIGS. 1A-1C for flow rates of 2.0-4.0 LPM. The simulated values listed in Tables 1 and 2 are accurate to within three percent of empirical results.

**Table 2. Pressure drop vs. flow rate for orthogonal and impingement cold plate designs.**

| | Cold plate design | | |
|---|---|---|---|
| Flow rate (LPM) | FIGS. 1A-1C (Pa) | Orthogonal (Pa) | Improvement |
| 1.0 | 2.1 | 2.3 | - |
| 2.0 | 5.5 | 4.4 | 25% |
| 3.0 | 10.0 | 7.2 | 39% |
| 4.0 | 14.5 | 9.6 | 51% |

From Bernoulli's equation, with the inclusion of head loss the power required to deliver a pressure drop for a given flow is given by the equation: pressure drop = pumping power / mg. Thus, any reduction in pressure drop translates to direct savings in pumping power. Simulation results suggest that the orthogonal cold plates disclosed herein can provide a thermal advantage of 5-7 °C (or about one performance bin) of thermal performance at 26-50% less pumping power over the impingement cold plate illustrated in FIGS. 1A-1C. This reduction of pumping power can lower the total cost of ownership of systems using the orthogonal cold plate designs disclosed herein.

In the following description, specific details are set forth, but embodiments of the technologies described herein may be practiced without these specific details. Well-known circuits, structures, and techniques have not been shown in detail to avoid obscuring an understanding of this description. Phrases such as "an embodiment," "various embodiments," "some embodiments," and the like may include features, structures, or characteristics, but not every embodiment necessarily includes the particular features, structures, or characteristics.

Some embodiments may have some, all, or none of the features described for other embodiments. "First," "second," "third," and the like describe a common object and indicate different instances of like objects being referred to. Such adjectives do not imply objects so described must be in a given sequence, either temporally or spatially, in ranking, or any other manner. "Connected" may indicate elements are in direct physical or electrical contact with each other and "coupled" may indicate elements co-operate or interact with each other, but they may or may not be in direct physical or electrical contact. Furthermore, the terms "comprising," "including," "having," and the like, as used with respect to embodiments of the present disclosure, are synonymous.

Terms modified by the word "substantially" include arrangements, orientations, spacings, or positions that vary slightly from the meaning of the unmodified term. For example, surfaces that are described as being "substantially in parallel" include surfaces that are within a few degrees of being parallel, directions that are described as being "substantially orthogonal" include directions that are within a few degrees of being at right angles to each other, a channel that is "substantially straight" includes channels that may deviate a small amount from a perfectly straight line, and features that are "substantially the same" or "substantially uniform" includes features that are within 5% of the listed feature (e.g., size, height).

As used herein, the phrase "located on" in the context of a first layer or component located on a second layer or component refers to the first layer or component being directly physically attached to the second part or component (no layers or components between the first and second layers or components) or physically attached to the second layer or component with one or more intervening layers or components. As used herein, the term "adjacent" refers to layers or components that are arranged next to each other (e.g., side-by-side, top and bottom).

Certain terminology may also be used herein for the purpose of reference only, and thus are not intended to be limiting. For example, terms such as "upper," "lower," "above," "below," "bottom," and "top" refer to directions in the Figures to which reference is made. Terms such as "front," "back," "rear," and "side" describe the orientation and/or location of layers, components, portions of components, etc., within a consistent but arbitrary frame of reference, which is made clear by reference to the text and the associated Figures describing the layers, component, portions of components, etc. under discussion. Such terminology may include the words specifically mentioned above, derivatives thereof, and words of similar import.

As used herein, the term "integrated circuit component" refers to a packaged or unpacked integrated circuit product. A packaged integrated circuit component comprises one or more integrated circuit dies mounted on a package substrate with the integrated circuit dies and package substrate encapsulated in a casing material, such as a metal, plastic, glass, or ceramic. In one example, a packaged integrated circuit component contains one or more processor units mounted on a substrate with an exterior surface of the substrate comprising a solder ball grid array (BGA). In one example of an unpackaged integrated circuit component, a single monolithic integrated circuit die comprises solder bumps attached to contacts on the die. The solder bumps allow the die to be directly attached to a printed circuit board. An integrated circuit component can comprise one or more of any computing system component described or referenced herein or any other computing system component, such as a processor unit (e.g., system-on-a-chip (SoC), processor core, graphics processor unit (GPU), accelerator, chipset processor), I/O controller, memory, or network interface controller.

Reference is now made to the drawings, which are not necessarily drawn to scale, wherein similar or same numbers may be used to designate same or similar parts in different figures. The use of similar or same numbers in different figures does not mean all figures including similar or same numbers constitute a single or same embodiment. Like numerals having different letter suffixes may represent different instances of similar components. The drawings illustrate generally, by way of example, but not by way of limitation, various embodiments discussed in the present document.

In the following description, for purposes of explanation, numerous specific details are set forth in order to provide a thorough understanding thereof. It may be evident, however, that the novel embodiments can be practiced without these specific details. In other instances, well-known structures and devices are shown in block diagram form in order to facilitate a description thereof. The intention is to cover all modifications, equivalents, and alternatives within the scope of the claims.

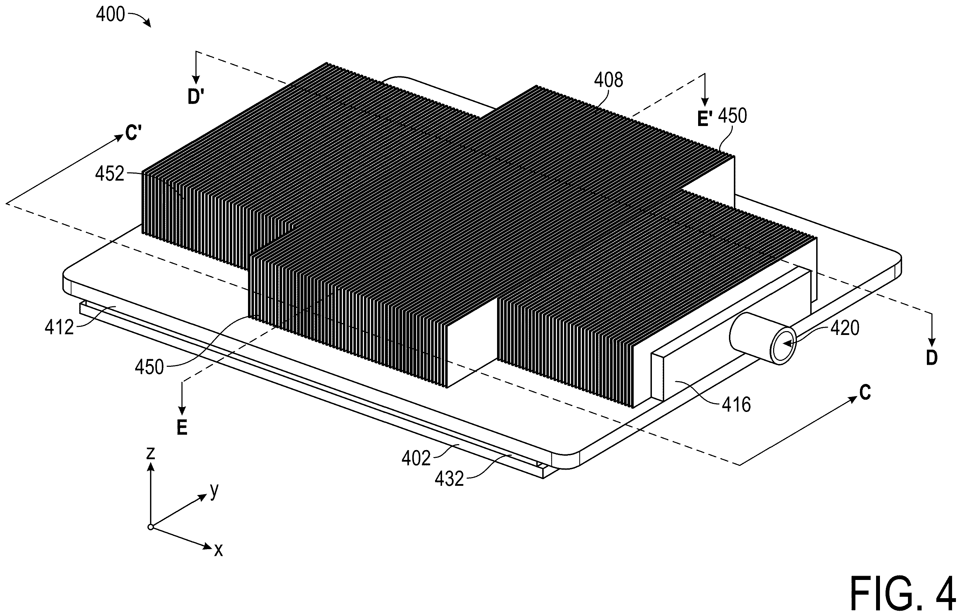

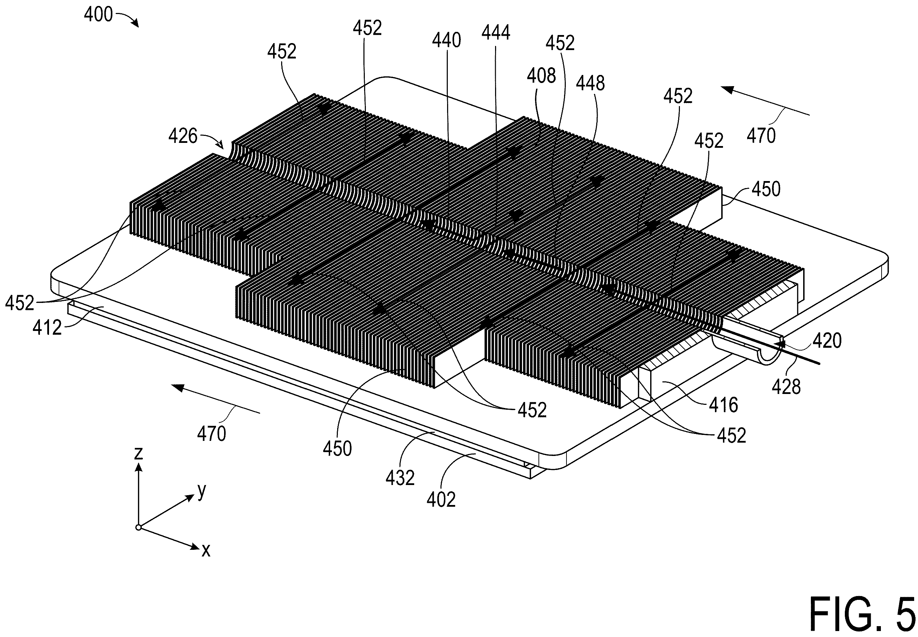

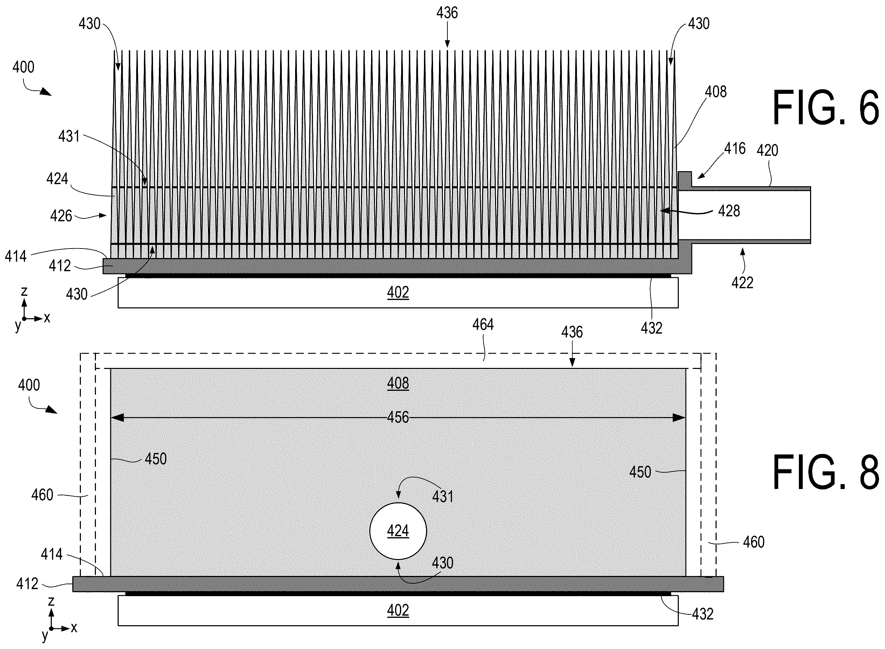

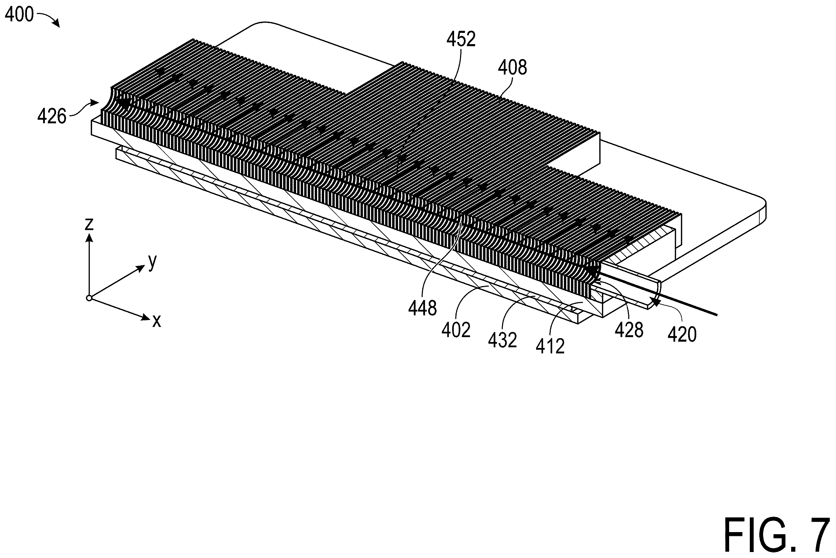

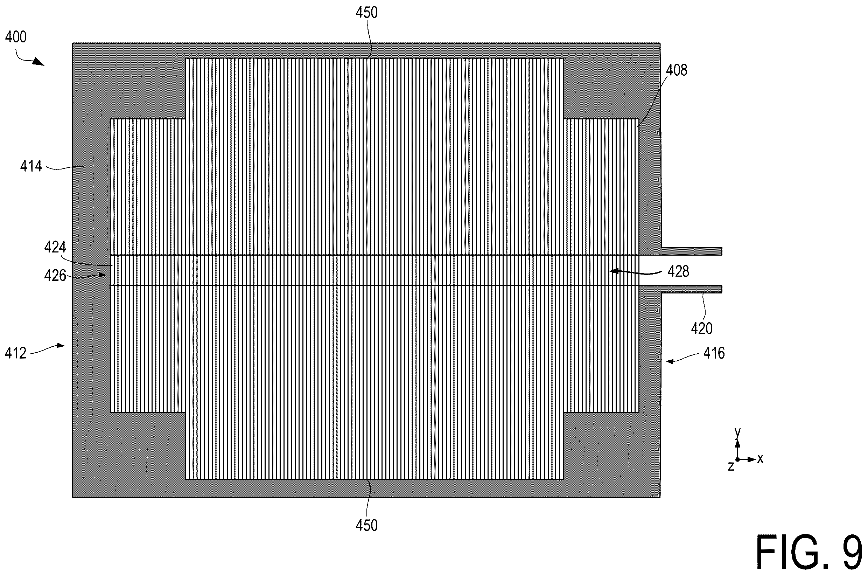

FIGS. 4-9 are various views of a first example orthogonal cold plate assembly. FIG. 4 is a perspective view of a cold plate assembly 400. FIG. 5 is a cross-sectional perspective view of the cold plate assembly 400 taken along line C- C', FIG. 6 is a cross-sectional view of the cold plate assembly 400 taken along line D-D', FIG. 7 is a perspective cross-sectional view of the cold plate assembly 400 taken along lines C-C' and D-D', FIG. 8 is a cross-sectional view of the cold plate assembly 400 taken along line E-E', and FIG. 9 is a cross-sectional top-down view of the cold plate assembly 400 taken along line C-C'.

The cold plate assembly 400 comprises fins 408, base plate 412, end 416, and inlet 420. The cold plate assembly 400 is attached to an integrated circuit component 402. The fins 408 extend upwards from a surface 414 of the base plate 412 and are arranged substantially in parallel. Adjacent fins 408 have a channel 430 between them. The fins 408 can have the same or non-uniform thickness and can have the same or non-uniform spacing (that is, the channel 428 between different pairs of adjacent fins can be the same or different). The base plate 412 and the fins 408 comprise a metal (e.g., copper and/or aluminum) or other suitable thermally conductive material. In some embodiments, the cold plate comprises a vapor chamber and/or a heat spreader positioned between the integrated circuit component (e.g., 402) and the fins (e.g., 408).

In general, the fins 408 have a fine pitch to present a large surface area to coolant passing through the cold plate to have a high degree of heat transfer between the fins 408 and the coolant. The individual fins 408 comprise an opening 424. The openings 424 of the fins 408 collectively define a continuous and substantially straight channel 428 that extends through the fins 408. The channel 428 is substantially parallel with the surface 414 of the base plate 412 and extends in a first direction 440 that is substantially orthogonal to a second direction 444 along which the fins 408 extend lengthwise. The openings 424 of the fins 408 are located at a substantially uniform height from the surface 414 of the base plate 412. The openings 424 can have any suitable shape, such as a circular, oval, or trapezoidal. The openings 424 can have substantially the same size, as illustrated in FIGS. 4-9 or have sizes that increase or decrease along the length of the channel 428. In embodiments where the size of the openings 424 varies along the length of the channel 428, the opening can increase or decrease in size from a first opening size near the inlet to a second opening size distal to the inlet. Further, the opening size can vary along the entirety or only along a portion of the length of the channel 428.

The channel 428 is tubeless. That is, there is no tube extending through the openings 424. Coolant flowing through a tubeless cold plate assembly, such as assembly 400 may experience a lower flow resistance than a cold plate assembly in which a tube is located in the channel 428. Cold plate assemblies comprising a tube located in openings in the fins are discussed below. The channel 428 is open-ended in that an end 426 of the channel 428 distal from the inlet 420 is open. In some embodiments, the channel 428 is closed-ended. A tubeless channel can be closed-ended by, for example, the fin furthest from the inlet not having an opening, the cold plate comprising a structure that plugs or covers the opening of the fin furthest from the inlet or closes the channel 428 in another suitable manner.

The openings 424 are located close to the base plate 412 so that there is a high degree of heat transfer between the integrated circuit component 402 and coolant flowing through the channel 428 and channels 430 when coolant is flowing through the cold plate assembly 400. In some embodiments, the channel 428 is located closer to the base plate 412 than tops 436 of the fins 408.

In some embodiments, such as the embodiment illustrated in FIGS. 4-9, the channel 428 is aligned with the inlet 420 to reduce the resistance experienced by the coolant flowing through cold plate assembly 400. In such embodiments, where a bottom 422 of the inlet 420 is raised relative to the surface 414 of the base plate 412, such as illustrated in FIGS. 4-9, bottoms 431 of the openings 424 are also raised from the surface 414 of the base plate 412. In other embodiments where the channel 428 is aligned with the inlet 420, the bottom of the inlet is flush with the top surface of the base plate, and the bottoms of the openings of the fins are flush with the top surface of the base plate as well. In other embodiments, the channel 428 comprises a groove in the surface 414 of the base plate 412 and the groove is aligned with openings in the plurality of fins. For example, in such embodiments, a channel can comprise circular openings with each circular opening comprising a minor segment comprising a portion of a rounded grove in the surface of a cold plate base plate and a major segment that comprises an opening in a fin. In yet other embodiments, the channel comprises cutouts in the bottom of the fins (where the fins meet the surface of the base plate of the cold plate). The cutouts can take any suitable shape (e.g., circular, oval, trapezoidal).

In some embodiments, the cold plate inlet is arranged with the channel such that the inlet in not a straight continuous extension of the channel. Such an inlet arrangement may be done to accommodate other components on a printed circuit board on which the cold plate assembly is to be placed, or to accommodate other cold plate assembly features. For example, the inlet may come into the cold plate assembly at an angle relative to the surface of the base plate of the cold plate. Having an inlet that is not a straight continuous extension of the channel may enable locating the channel closer to the base plate of the cold plate assembly. This may allow for a greater degree of heat exchange between an integrated circuit component to which the cold plate assembly is attached and coolant flowing through the cold plate assembly.

The openings 424 can be centered along the lengths (e.g., length 456) of the individual fins or at any other suitable location along the length of the fins. For example, the openings 424 may be offset from the center of the lengths of the fins the openings are positioned over a region of the integrated circuit component 402 capable of generating heat than other regions of the integrated circuit component that is offset from the center of the fins. The fins 408 can have non-uniform (as illustrated in FIGS. 4-9) lengths or a uniform length 456.

The cold plate assembly 400 is attached to the integrated circuit component 402 via a thermal interface material (TIM) layer 432. The TIM layer 432 can be any suitable material, such as a silver thermal compound, thermal grease, phase change materials, indium foils or graphite sheets. The cold plate assembly 400 can further be fastened to the integrated circuit component 402, a printed circuit board, a chassis, or other computing system component by one or more fasteners (not shown), or by another suitable retention mechanism.

The inlet 420 can receive coolant that is to flow through the cold plate assembly 400 to cool the integrated circuit component 402. The inlet 420 can be coupled by, for example, one or more tubes, to a coolant manifold of an immersion cooling tank and/or directly to an inlet of an immersion cooling tank within which the cold plate assembly 400 is located. Additionally or alternatively, the inlet 420 can receive coolant from any suitable coolant location that is upstream within an immersion cooling tank. In some examples, the inlet 420 can be coupled to a pump capable of driving coolant through the cold plate assembly 400.

In some embodiments, the integrated circuit component 402 can comprise an integrated heat spreader (IHS) and the base plate 412 can be in thermal contact with the IHS of the integrated circuit component 402. The TIM layer 432 facilitates the flow of heat from the integrated circuit component 402 to the cold plate assembly 400.

The cold plate assembly 400 can be disposed within the free ambient flow of coolant through an immersion cooling tank and/or within the interior of a chassis disposed within an immersion cooling tank. During cooling of the integrated circuit component 402 by a liquid immersion cooling thermal management solution utilizing cold plate assembly 400, coolant is forced (via pumping) into the cold plate assembly 400 through the inlet 420. The coolant flows first through channel 428 (as indicated by arrow 448) and then through channels 430 between the fins 408 (as indicated by arrows 452). Heat generated by the integrated circuit component 402 that has transferred to the fins 408 is absorbed via convection into the coolant, thereby cooling the cold plate assembly 400 (e.g., via convection, via conduction, etc.) and the integrated circuit component 402 coupled thereto. After exiting the channels 430 at ends 450 of the fins 408, the coolant enters an ambient flow 470 of coolant through an immersion cooling tank and/or a chassis including the cold plate assembly 400. It should be appreciated that a portion of the coolant can leave the cold plate assembly 400 via tops 436 of the fins 408.

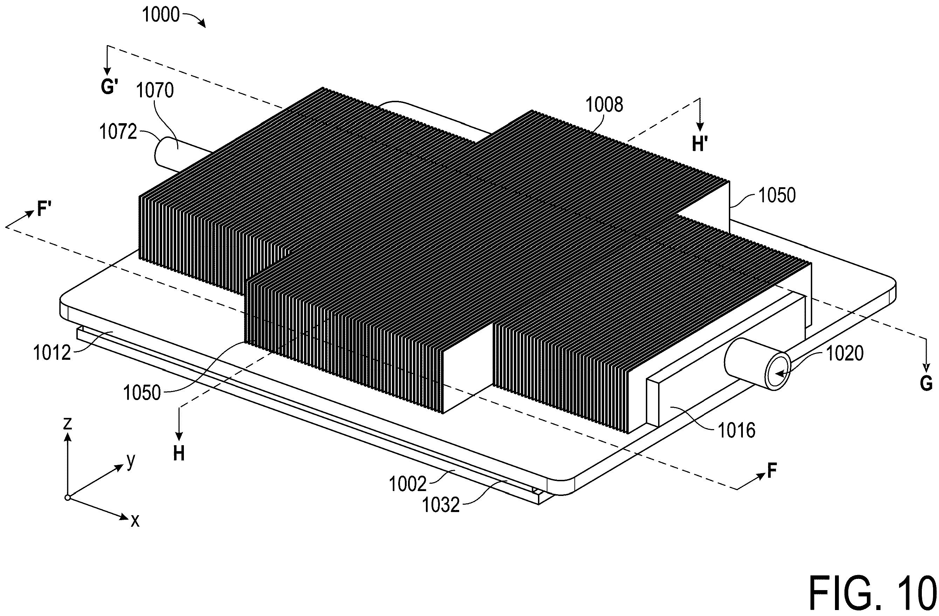

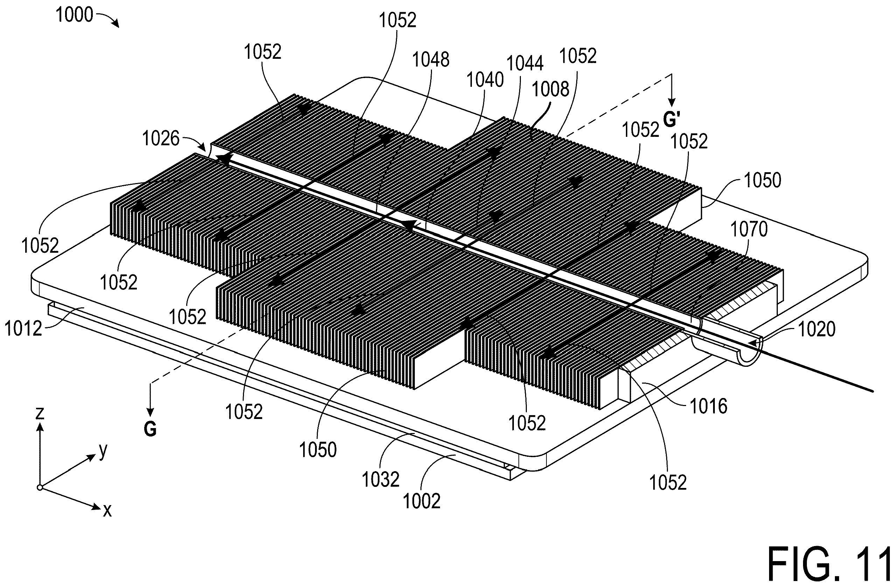

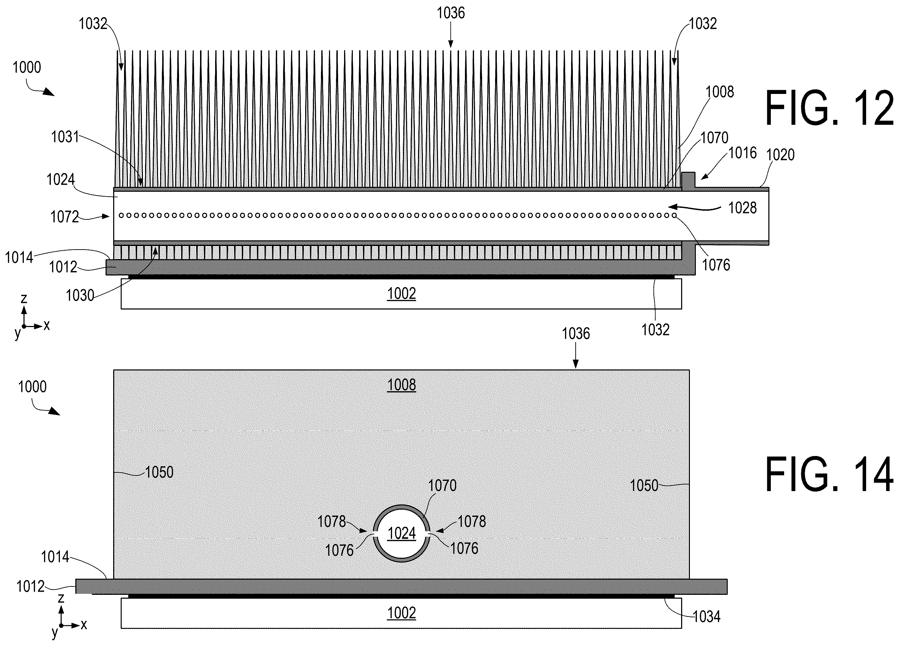

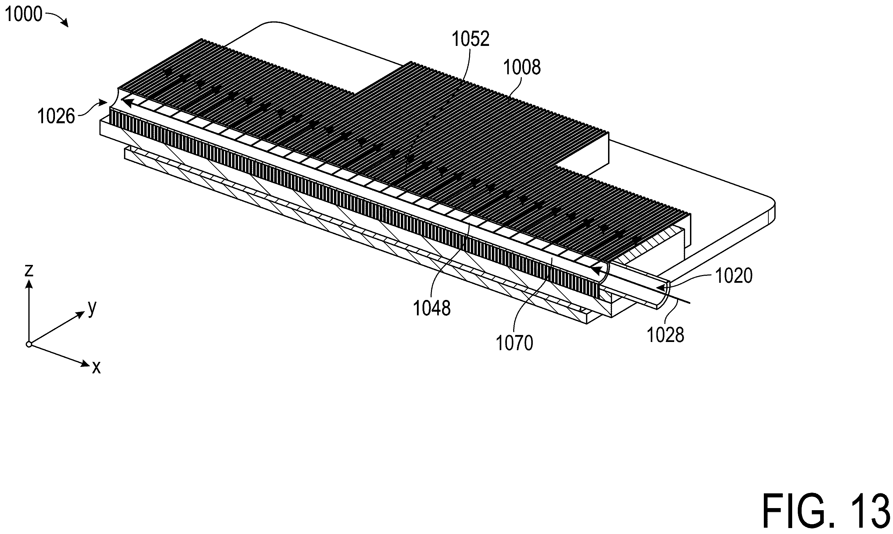

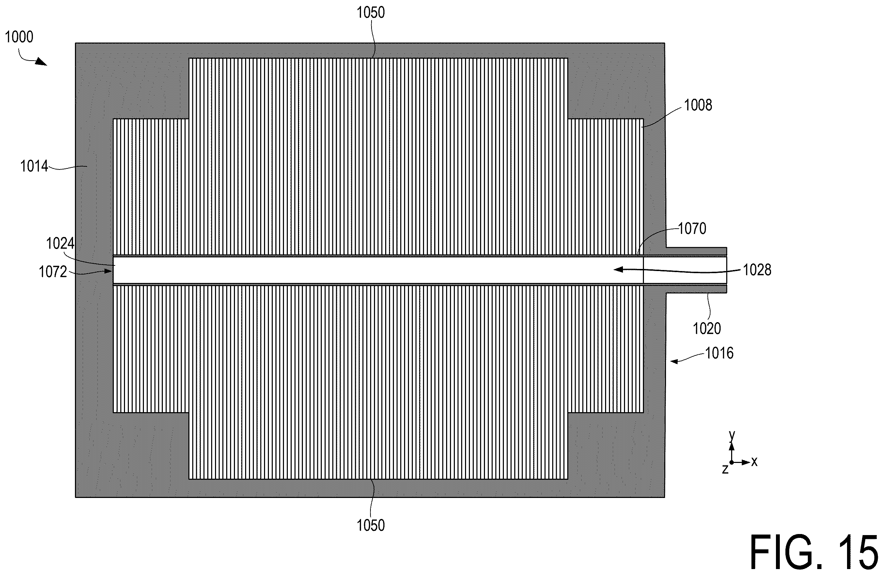

FIGS. 10-15 are various views of a second example orthogonal cold plate assembly. FIG. 10 is a perspective view of the cold plate assembly 1000. FIG. 11 is a cross-sectional perspective view of the cold plate assembly 1000 taken along line F-F', FIG. 12 is a cross-sectional view of the cold plate assembly 1000 taken along lines G-G', FIG. 13 is a cross-sectional view of the cold plate assembly 1000 taken along lines F-F' and G-G', FIG. 14 is a perspective cross-sectional view of the cold plate assembly 1000 taken along line H-H', and FIG. 15 is a cross-sectional top-down view of the cold plate assembly 1000 taken along line F-F'.

The cold plate assembly 1000 comprises fins 1008, base plate 1012, end 1016, inlet 1020, and an integrated circuit component 1002, with openings in the fins 1008 defining a channel 1028. Cold plate assembly 1000 is similar to cold plate assembly 400 but with the addition of a tube 1070 positioned within the channel 1028. The descriptions above for the elements and features of FIGS. 4-9 apply to like-numbered elements features of FIGS. 10-15. For example, openings 1024, fins 1008, and base plate 1012 in FIGS. 10-15 are described by the descriptions provided above for openings 424, fins 408, and base plate 412.

The tube 1070 can be insertable or embedded and has the inlet 1020 as a first end and a second end 1072 that is opposite to the inlet 1020. The tube 1070 is also shown as extending through the entirety of the channel 1028 (through all of the fins 1008), but in other embodiments, the tube 1070 can pass through only a portion of the channel 1028 (through fewer than all of the fins 1008). In some embodiments, the tube 1070 comprises a metal (e.g., copper and/or aluminum) or other thermally conductive material. The tube 1070 is circular but can have any other shape that fits the openings 1024 (e.g., elliptical, trapezoidal). The tube 1070 is open-ended (second end 1072 is open) but in other embodiments the tube 1070 is closed-ended. The second end 1072 can be closed by, for example, a discrete cap attached to or formed integrally with the tube 1070. As such, in closed-ended tubed cold plate assembly embodiments, all coolant that enters the tube 1070 via the inlet 1020 exits the cold plate assembly 1000 by flowing through the fins 1008.

With reference to FIGS. 12-13, the tube 1070 comprises a row of openings 1076 on sides 1078 of the tube 1070 to allow coolant to flow from channel 1028 to channels 1032. The openings 1076 have a circular shape. The openings 1076 can be arranged such that individual openings at least partially overlap with at least one of the channels 1032. In other embodiments, the openings 1076 can have any arrangement (and have any suitable shape and number) that directs the coolant from the channel 1028 in a lateral direction into the channels 1032 and towards the ends 1050 of the fins 1008. In some embodiments, the openings in the tube may direct at least some of the coolant in a direction that has a downwards component (towards the surface 1014 of the base plate 1012), but with the downward component being less than a lateral component of the direction of coolant flow from the openings 1076. Directing coolant in a direction laterally from the tube 1070 instead of downwards, where it can impinge the surface 1014 of the base plate can reduce the flow resistance experienced by the coolant as it flows through the cold plate assembly 1000.

Any of the cold plate assemblies disclosed herein can optionally comprise sidewalls located adjacent to and spaced from ends (450, 1050) of the fins (408, 1008) and/or a cover attached to a top (436, 1036) of one or more fins. FIG. 8 illustrates example optional sidewalls 460 and an optional top 464. Cold plate assembly sidewalls can be separate from or formed integral with a cold plate assembly top. In some embodiments, a cover can provide structural stability to the cold plate assembly.

The cold plate assemblies disclosed herein can be used with any suitable coolant, such as a hydrocarbon, mineral oil, or a synthetic dielectric (e.g., per- and polyfluoroalkyl substances (PFAS)).

In some embodiments, fins can for only a short distance past the tops of the openings in the fins, relative to the distance that the fins are shown as extending past the tops of the openings in the fins in cold plate assemblies 400 and 1000. Shorter fans can allow for a lower flow resistance (by reducing the flow resistance seen by the coolant that flows out of the cold plate through the tops of the fins) and cold plate assemblies that have a lower overall height.

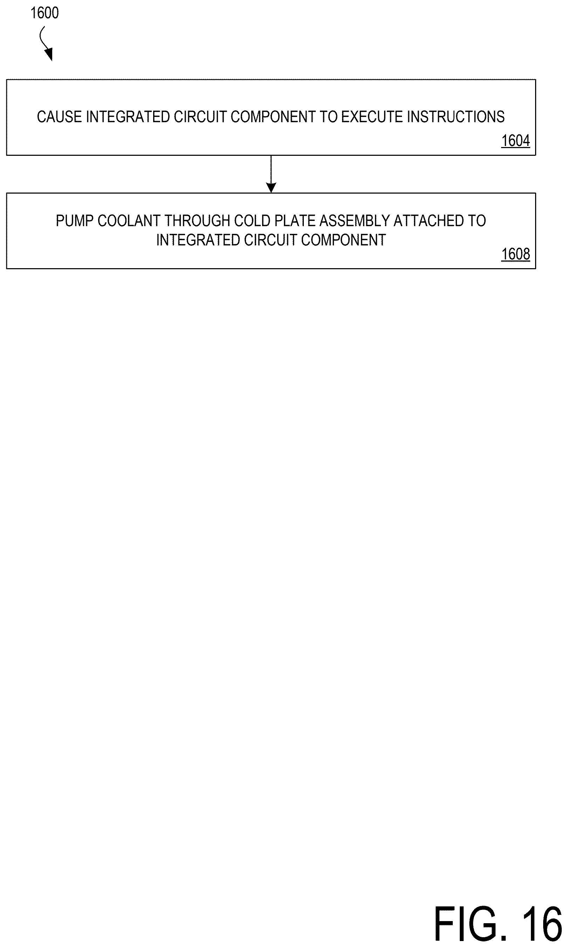

FIG. 16 is an example method of cooling an integrated circuit component via a thermal management solution utilizing an orthogonal cold plate assembly in accordance with any of the embodiments disclosed herein. The method 1600 can be performed by, for example, an operator of a data center utilizing liquid immersion cooling to cool servers in its data center. At stage 1604, an integrated circuit component is caused to execute instructions. At stage 1608, coolant is pumped through a cold plate assembly attached to the integrated circuit component.

The cold plate assemblies described herein can be used in the liquid immersion cooling of any processor unit or integrated circuit component described or referenced herein. An integrated circuit component attached to any of the cold plate assemblies described herein. In some embodiments, one or more additional integrated circuit components or other components can be attached to the printed circuit board. The printed circuit board, integrated circuit component and cold plate assembly can be located in an immersion tank and at least partially submerged in coolant. In some embodiments, the printed circuit board, integrated circuit component and cold plate assembly are fully submerged in the coolant. The coolant can be circulated via pumping. The immersion tank can be connected to a heat exchanger and a pump by one of more conduits, with the pump causing the coolant to circulate between the immersion tank and the heat exchanger. In some embodiments, the printed circuit board and the integrated circuit component can be located in a chassis.

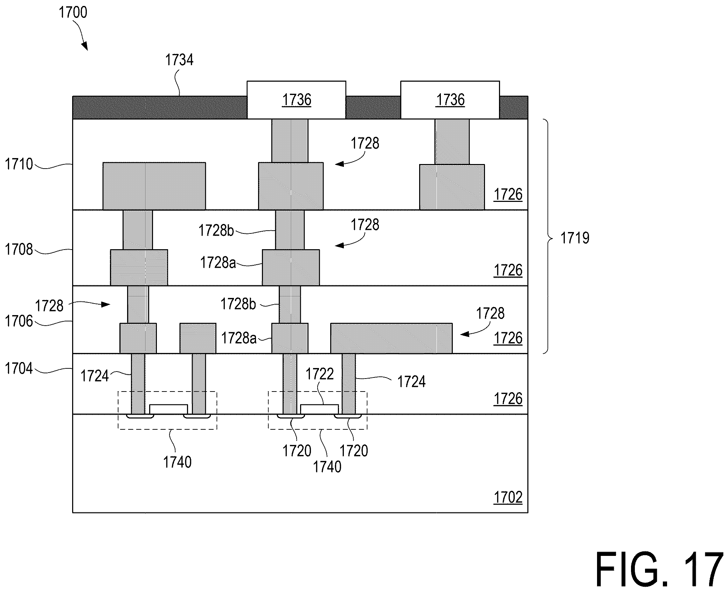

FIG. 17 is a cross-sectional view of an integrated circuit structure 1700 that may be included in any of the integrated circuit components disclosed herein. The integrated circuit structure 1700 may be formed on a die substrate 1702. The die substrate 1702 may be a semiconductor substrate composed of semiconductor material including, for example, n-type or p-type materials (or a combination of both). The die substrate 1702 may include, for example, a crystalline substrate formed using a bulk silicon or a silicon-on-insulator (SOI) substructure. In some embodiments, the die substrate 1702 can comprise a layer of silicon on top of an SOI layer with bulk silicon below the SOI layer. In some embodiments, the die substrate 1702 may be formed using alternative materials, which may or may not be combined with silicon, that include, but are not limited to, germanium, indium antimonide, lead telluride, indium arsenide, indium phosphide, gallium arsenide, or gallium antimonide. Further materials classified as group II-VI, III-V, or IV may also be used to form the die substrate 1702. Although a few examples of materials from which the die substrate 1702 may be formed are described here, any material that may serve as a foundation for an integrated circuit structure 1700 may be used.

The integrated circuit structure 1700 may include device layer 1704 disposed on the die substrate 1702. The device layer 1704 may include features of transistors 1740 (e.g., metal oxide semiconductor field-effect transistors (MOSFETs)) formed on the die substrate 1702. The transistors 1740 may include, for example, source and drain regions (S/D regions 1720), a gate 1722 to control current flow between the S/D regions 1720, and S/D contacts 1724 to route electrical signals to and from the S/D regions 1720. The transistors 1740 may include additional features not depicted for the sake of clarity, such as device isolation regions, gate contacts, and the like. The transistors 1740 are not limited to the type and configuration depicted in FIG. 17 and may include a wide variety of other types and configurations such as, for example, non-planar transistors, or a combination of planar and non-planar transistors. Non-planar transistors may include FinFET transistors, such as double-gate transistors or tri-gate transistors, and wrap-around or all-around gate transistors, such as nanoribbon, nanosheet, or nanowire transistors.

Transistors 1740 may include a gate 1722 formed of at least two layers, a gate dielectric, and a gate electrode. The gate dielectric may include one or more layers. The one or more layers may include silicon oxide, silicon dioxide, silicon carbide, and/or a high-k dielectric material.

The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric to improve its quality when a high-k material is used.

The gate electrode may be formed on the gate dielectric and may include at least one p-type work function metal or n-type work function metal, depending on whether the transistor is to be a p-type metal oxide semiconductor (PMOS) or an n-type metal oxide semiconductor (NMOS) transistor. In some implementations, the gate electrode may consist of a stack of two or more metal layers, where one or more metal layers are work function metal layers and at least one metal layer is a fill metal layer. Further metal layers may be included for other purposes, such as a barrier layer.

For PMOS transistors, metals that may be used for the gate electrode include, but are not limited to, ruthenium, palladium, platinum, cobalt, nickel, conductive metal oxides (e.g., ruthenium oxide), and any of the metals discussed below with reference to an NMOS transistor (e.g., for work function tuning). For NMOS transistors, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and aluminum carbide), and any of the metals discussed above with reference to a PMOS transistor (e.g., for work function tuning).

In some embodiments, when viewed as a cross-section of the transistor 1740 along the source-channel-drain direction, the gate electrode may consist of a U-shaped structure that includes a bottom portion substantially parallel to the surface of the die substrate 1702 and two sidewall portions that are substantially perpendicular to the top surface of the die substrate 1702. In other embodiments, at least one of the metal layers that form the gate electrode may simply be a planar layer that is substantially parallel to the top surface of the die substrate 1702 and does not include sidewall portions substantially perpendicular to the top surface of the die substrate 1702. In other embodiments, the gate electrode may consist of a combination of U-shaped structures and planar, non-U-shaped structures. For example, the gate electrode may consist of one or more U-shaped metal layers formed atop one or more planar, non-U-shaped layers.

In some embodiments, a pair of sidewall spacers may be formed on opposing sides of the gate stack (comprising the gate dielectric and the gate electrode) to bracket the gate stack. The sidewall spacers may be formed from materials such as silicon nitride, silicon oxide, silicon carbide, silicon nitride doped with carbon, and silicon oxynitride. Processes for forming sidewall spacers are well known in the art and generally include deposition and etching process steps. In some embodiments, a plurality of sidewall spacer pairs may be used; for instance, two pairs, three pairs, or four pairs of sidewall spacers may be formed on opposing sides of the gate stack.

The S/D regions 1720 may be formed within the die substrate 1702 adjacent to the gate 1722 of transistors 1740. The S/D regions 1720 may be formed using an implantation/diffusion process or an etching/deposition process, for example. In the former process, dopants such as boron, aluminum, antimony, phosphorous, or arsenic may be ion-implanted into the die substrate 1702 to form the S/D regions 1720. An annealing process that activates the dopants and causes them to diffuse further into the die substrate 1702 may follow the ion implantation process. In the latter process, the die substrate 1702 may first be etched to form recesses at the locations of the S/D regions 1720. An epitaxial deposition process may then be carried out to fill the recesses with material that is used to fabricate the S/D regions 1720. In some implementations, the S/D regions 1720 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 1720 may be formed using one or more alternate semiconductor materials such as germanium or a group III-V material or alloy. In further embodiments, one or more layers of metal and/or metal alloys may be used to form the S/D regions 1720.

Electrical signals, such as power and/or information-carrying signals (e.g., input/output (I/O) signals, may be routed to and/or from devices (e.g., transistors 1740) of the device layer 1704 through one or more interconnect layers disposed on the device layer 1704 (illustrated in FIG. 17 as interconnect layers 1706-1710). For example, electrically conductive features of the device layer 1704 (e.g., the gate 1722 and the S/D contacts 1724) may be electrically coupled with interconnect structures 1728 of the interconnect layers 1706-1710. The one or more interconnect layers 1706-1710 may form a metallization stack 1719 (which can also be referred to as an "ILD stack" (inter-layer dielectric stack)) of the integrated circuit structure 1700.

The interconnect structures 1728 may be arranged within the interconnect layers 1706-1710 to route electrical signals according to a wide variety of designs; in particular, the arrangement is not limited to the particular configuration of interconnect structures 1728 depicted in FIG. 17. Although a particular number of interconnect layers 1706-1710 is depicted in FIG. 17, embodiments of the present disclosure include integrated circuit structures having more or fewer interconnect layers than depicted.

In some embodiments, the interconnect structures 1728 may include traces or lines 1728a and/or vias 1728b filled with an electrically conductive material such as a metal. The lines 1728a may be arranged to route electrical signals in a direction of a plane that is substantially parallel with a surface of the die substrate 1702 upon which the device layer 1704 is formed. For example, the lines 1728a may route electrical signals in a direction in and out of the page and/or in a direction across the page from the perspective of FIG. 17. The vias 1728b may be arranged to route electrical signals in a direction of a plane that is substantially perpendicular to the surface of the die substrate 1702 upon which the device layer 1704 is formed. In some embodiments, lines 1728a of different interconnect layers 1706-1710 are electrically coupled by vias 1728b.

The interconnect layers 1706-1710 may include a dielectric material 1726 within which the interconnect structures 1728 are disposed, as shown in FIG. 17. In some embodiments, dielectric material 1726 in different ones of the interconnect layers 1706-1710 may have different compositions; in other embodiments, the composition of the dielectric material 1726 between different interconnect layers 1706-1710 may be the same. The device layer 1704 may include a dielectric material 1726 within which the transistors 1740 are disposed and upon which a bottom layer of the metallization stack is located. The dielectric material 1726 that is part of the device layer 1704 may have a different composition than the dielectric material 1726 included in the interconnect layers 1706-1710; in other embodiments, the composition of the dielectric material 1726 in the device layer 1704 may be the same as a dielectric material 1726 included in any one of the interconnect layers 1706-1710.

A first interconnect layer 1706 (which can be referred to as a Metal 1 or "M1" layer) may be formed directly on the device layer 1704. In some embodiments, the first interconnect layer 1706 may include lines 1728a and/or vias 1728b, as shown. The lines 1728a of the first interconnect layer 1706 may be coupled with contacts (e.g., the S/D contacts 1724) of the device layer 1704. The vias 1728b of the first interconnect layer 1706 may be coupled with the lines 1728a of a second interconnect layer 1708.

The second interconnect layer 1708 (which can be referred to as a Metal 2 or "M2" layer) may be formed directly on the first interconnect layer 1706. In some embodiments, the second interconnect layer 1708 may include vias 1728b to couple the lines 1728a of the second interconnect layer 1708 with the lines 1728a of a third interconnect layer 1710. Although the lines 1728a and the vias 1728b are structurally delineated with a line within individual interconnect layers for the sake of clarity, the lines 1728a and the vias 1728b may be structurally and/or materially contiguous (e.g., simultaneously filled during a dual-damascene process) in some embodiments.

The third interconnect layer 1710 (which can be referred to as a Metal 3 or "M3" layer) (and additional interconnect layers, as desired) may be formed in succession on the second interconnect layer 1708 according to similar techniques and configurations described in connection with the second interconnect layer 1708 or the first interconnect layer 1706. In some embodiments, the interconnect layers that are "higher up" in the metallization stack 1719 in the integrated circuit structure 1700 (i.e., farther away from the device layer 1704) may be thicker than the interconnect layers that are lower in the metallization stack 1719, with lines 1728a and vias 1728b in the higher interconnect layers being thicker than those in the lower interconnect layers.

The integrated circuit structure 1700 may include a solder resist material 1734 (e.g., polyimide or similar material) and conductive contacts 1736 formed on the stack of interconnect layers 1706-1710. In FIG. 17, the conductive contacts 1736 are illustrated as taking the form of bond pads. The conductive contacts 1736 may be electrically coupled with interconnect structures 1728 of the top-most layer in the metallization stack 1719 and configured to route electrical signals between the transistors 1740 and components external to the integrated circuit structure 1700. For example, solder bonds may be formed on the conductive contacts 1736 to mechanically and/or electrically couple an integrated circuit component comprising the integrated circuit structure 1700 with another component (e.g., a printed circuit board). The integrated circuit structure 1700 may include additional or alternate structures to route electrical signals from the interconnect layers 1706-1710; for example, the conductive contacts 1736 may include other analogous features (e.g., posts) that can route the electrical signals between the transistors 1740 and external components.

In some embodiments in which the integrated circuit structure 1700 is a double-sided die, the integrated circuit structure 1700 may include another metallization stack (not shown) on the opposite side of the device layer 1704. This metallization stack may include multiple interconnect layers as discussed above with reference to the interconnect layers 1706-1710, to provide conductive pathways (e.g., including conductive lines and vias) between the device layer 1704 and additional conductive contacts (not shown) on the opposite side of the integrated circuit structure 1700 from the conductive contacts 1736.

In some embodiments, TSVs extending through the die substrate 1702 can be used for routing power and ground signals from conductive contacts located on the opposite side of the integrated circuit structure 1700 from the conductive contacts 1736 to the transistors 1740 and any other components integrated into the integrated circuit structure 1700, and the metallization stack 1719 can be used to route information-carrying signals from the conductive contacts 1736 to transistors 1740 and any other components integrated into the integrated circuit structure 1700. Put another way, the routing of power and ground signals to the transistors 1740 can be separated (via a back-side or bottom-side metallizaton stack and TSVs) from the routing of information-carrying signals to the transistors. The power and ground signals are provided by a back-side or bottom-side metallization stack and TSVs, and information-carrying signals are provide by a top-side metallization stack (e.g.,metallization stack 1719).

Several integrated circuit dies may be stacked with one or more TSVs in the individual stacked dies providing connection between one of the dies to any of the other dies in the stack. For example, one or more high-bandwidth memory (HBM) integrated circuit dies can be stacked on top of a base integrated circuit die and TSVs in the HBM dies can provide connection between the individual HBM dies and the base integrated circuit die. Conductive contacts can provide additional connections between adjacent integrated circuit dies in the stack. In some embodiments, the conductive contacts can be fine-pitch solder bumps (microbumps).

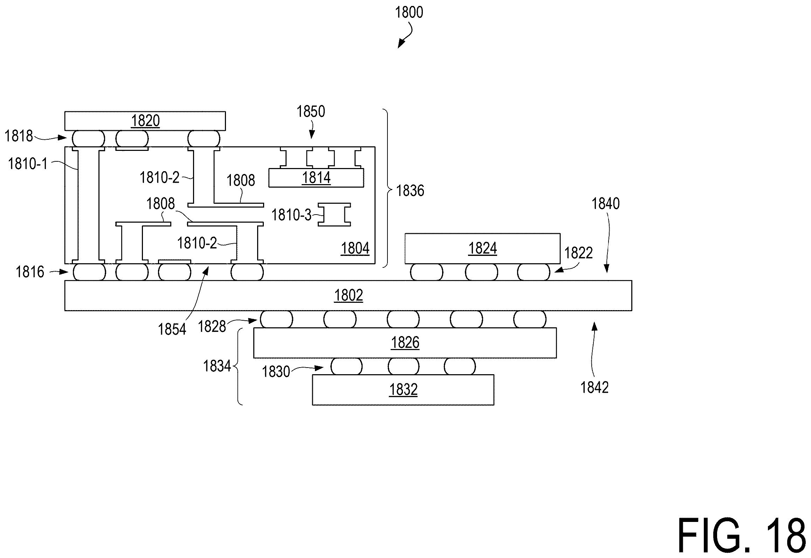

FIG. 18 is a cross-sectional view of an integrated circuit device assembly 1800 that may include any of the cold plate assemblies (e.g., 400, 1000) disclosed herein. The integrated circuit device assembly 1800 includes a number of components disposed on a circuit board 1802 (which may be a motherboard, system board, mainboard, etc.). The integrated circuit device assembly 1800 includes components disposed on a first face 1840 of the circuit board 1802 and a second face 1842 of the circuit board 1802, the second face 1842 opposing the first face 1840. Generally, components may be disposed on either or both of the first face 1840 and the second face 1842 of the circuit board 1802; generally, components may be disposed on one or both of first face 1840 and second face 1842.

In some embodiments, the circuit board 1802 may be a printed circuit board (PCB) including multiple metal (or interconnect) layers separated from one another by layers of dielectric material and interconnected by electrically conductive vias. The individual metal layers comprise conductive traces. The metal layers may be formed in a desired pattern to route electrical signals between the components electrically coupled to the circuit board 1802. In other embodiments, the circuit board 1802 may be a non-PCB substrate.

The integrated circuit device assembly 1800 illustrated in FIG. 18 includes a package-on-interposer structure 1836 coupled to the first face 1840 of the circuit board 1802 by coupling components 1816. The coupling components 1816 may electrically and mechanically couple the package-on-interposer structure 1836 to the circuit board 1802 and may include solder balls (as shown in FIG. 18), pins (e.g., as part of a pin grid array (PGA), contacts (e.g., as part of a land grid array (LGA)), male and female portions of a socket, an adhesive, an underfill material, and/or any other suitable electrical and/or mechanical coupling structure. (Thus, a coupling component may comprise a conductive contact.) The coupling components 1816 may serve as the coupling components illustrated or described for any of the substrate assembly or substrate assembly components described herein, as appropriate.

The package-on-interposer structure 1836 may include an integrated circuit component 1820 coupled to an interposer 1804. The interposer 1804 may provide an intervening substrate used to bridge the circuit board 1802 and the integrated circuit component 1820. The integrated circuit component 1820 is coupled to the interposer 1804 by coupling components 1818. The coupling components 1818 may take any suitable form, such as the forms discussed above with reference to the coupling components 1816. Although FIG. 18 shows just one integrated circuit component attached to the interposer, multiple integrated circuit components may be coupled to the interposer 1804. Additional interposers may be coupled to the interposer 1804.

The integrated circuit component 1820 may be a packaged or unpacked integrated circuit product that includes one or more integrated circuits, the integrated circuit structure 1700 of FIG. 17) and/or one or more other suitable components. A packaged integrated circuit component comprises one or more integrated circuit dies mounted on a package substrate with the integrated circuit dies and package substrate encapsulated in a casing material, such as a metal, plastic, glass, or ceramic. In one unpackaged example of an integrated circuit component 1820, a single monolithic integrated circuit die comprises solder bumps attached to contacts on the die. The solder bumps allow the die to be directly attached to the interposer 1804. The integrated circuit component 1820 can comprise one or more computing system components, such as one or more processor units (e.g., system-on-a-chip (SoC), processor core, graphics processor unit (GPU), accelerator, chipset processor), I/O controller, memory, or network interface controller. In some embodiments, the integrated circuit component 1820 can comprise one or more additional active or passive devices such as capacitors, decoupling capacitors, resistors, inductors, fuses, diodes, transformers, sensors, electrostatic discharge (ESD) devices, and memory devices.

In embodiments where the integrated circuit component 1820 comprises multiple integrated circuit dies, the dies can be of the same type (a homogeneous multi-die integrated circuit component) or of two or more different types (a heterogeneous multi-die integrated circuit component). A multi-die integrated circuit component can be referred to as a multi-chip package (MCP) or multi-chip module (MCM).

In addition to comprising one or more processor units, the integrated circuit component 1820 can comprise additional components, such as embedded DRAM, stacked high bandwidth memory (HBM), shared cache memories, input/output (I/O) controllers, or memory controllers. Any of these additional components can be located on the same integrated circuit die as a processor unit, or on one or more integrated circuit dies separate from the integrated circuit dies comprising the processor units. These separate integrated circuit dies can be referred to as "chiplets". In embodiments where an integrated circuit component comprises multiple integrated circuit dies, interconnections between dies can be provided by the package substrate, one or more silicon interposers, one or more silicon bridges embedded in the package substrate (such as Intel^{®} embedded multi-die interconnect bridges (EMIBs)), or combinations thereof.

Generally, the interposer 1804 may spread connections to a wider or narrower pitch or reroute a connection to a different connection. For example, the interposer 1804 may couple coupling components 1818 having a first pitch to coupling components 1816 having a wider pitch than the first pitch. In the embodiment illustrated in FIG. 18, the integrated circuit component 1820 and the circuit board 1802 are attached to opposing sides of the interposer 1804. In other embodiments, the integrated circuit component 1820 and the circuit board 1802 may be attached to a same side of the interposer 1804. In some embodiments, three or more components may be interconnected by way of the interposer 1804.

In some embodiments, the interposer 1804 may be formed as a PCB, including multiple metal layers separated from one another by layers of dielectric material and interconnected by electrically conductive vias. In some embodiments, the interposer 1804 may be formed of an epoxy resin, a fiberglass-reinforced epoxy resin, an epoxy resin with inorganic fillers, a ceramic material, or a polymer material such as polyimide. In some embodiments, the interposer 1804 may be formed of alternate rigid or flexible materials that may include the same materials described above for use in a semiconductor substrate, such as silicon, germanium, and other group III-V and group IV materials. The interposer 1804 may include metal interconnects 1808 and vias, including but not limited to through hole vias 1810-1 (that extend from a first face 1850 of the interposer 1804 to a second face 1854 of the interposer 1804), blind vias 1810-2 (that extend from the first face 1850 or the second face 1854 of the interposer 1804 to an internal metal layer), and buried vias 1810-3 (that connect internal metal layers).

In some embodiments, the interposer 1804 can comprise a silicon interposer. Through silicon vias (TSV) extending through the silicon interposer can connect connections on a first face of a silicon interposer to an opposing second face of the silicon interposer. In some embodiments, an interposer 1804 comprising a silicon interposer can further comprise one or more routing layers to route connections on a first face of the interposer 1804 to an opposing second face of the interposer 1804.

In some embodiments the interposer 1804, as well as the circuit board 1802, can comprise an amorphous solid layer of glass (which can be referred to a glass core or glass substrate). In some embodiments, the layer of glass can comprise silica (comprising silicon dioxide (SiO₂)), fused silica, aluminosilicate (comprising aluminum oxide (Al₂O₃) and silicon dioxide), borosilicate (comprising silicon dioxide and boron trioxide (B₂O₃)), or alumino-borosilicate (comprising aluminum oxide, silicon dioxide, and boron trioxide). In some embodiments, the layer of glass can comprise one or more of the following additives: aluminum oxide, boron trioxide, magnesium oxide (MgO), calcium oxide (CaO), strontium oxide (SrO), barium oxide (BaO), tin(IV) oxide (SnO₂), nitrous oxide (Na₂O), potassium oxide (K₂O), diphosphorous trioxide (P₂O₃), zirconium dioxide (ZrO₂), lithium oxide (Li₂O), titanium, and zinc. In some embodiments, the layer of glass can comprise silicon and oxygen, as well as one or more of aluminum, boron, magnesium, calcium, barium, tin, sodium, potassium, strontium, phosphorous, zirconium, lithium, titanium, and zinc. In some embodiments, the layer of glass comprises at least 23 percent silicon by weight, at least 26 percent oxygen by weight, and at least five percent aluminum by weight. In some embodiments, the layer of glass does not include an organic adhesive or an organic material. For example, the layer of glass is not a substrate or a board comprising glass fibers and an epoxy binder, such as a printed circuit board (PCB) comprising multiple metal (or interconnect) layers separated from one another by layers of dielectric material (e.g., FR-4 or other fiberglass-reinforced epoxy laminate) and interconnected by electrically conductive vias.

In some embodiments, the glass layer has a thickness in the range of about 50 microns to about 1.4 millimeters. In some embodiments, the glass layer is or is part of a multi-layer glass substrate (a coreless substrate). Individual glass layers in a multi-layer glass substrate can have a thickness in the range of about 25 microns to about 50 microns. In some embodiments, a glass layer can have a length in the range of about 10 millimeters to about 250 millimeters on a side (e.g., can have an area in the range of about 10 mm x 10 mm to about 250 mm x 250 mm). In some embodiments, the glass layer comprises a rectangular prism volume with sections or portions (e.g., through-glass vias) removed and filled with other metals (e.g., metal).

In some embodiments, redistribution layers (RDL) can be located on either or both sides of the glass layer to provide electrically conductive paths from top and/or bottom surfaces of the interposer 1804 or circuit board 1802 to the glass layer. The glass layer can comprise through-glass vias (TGVs) that extend through the glass layer to provide electrically conductive paths through the glass core, glass substrate, or glass layer.

The interposer 1804 may further include embedded devices 1814, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the interposer 1804. The package-on-interposer structure 1836 may take the form of any of the package-on-interposer structures known in the art.

The integrated circuit device assembly 1800 may include an integrated circuit component 1824 coupled to the first face 1840 of the circuit board 1802 by coupling components 1822. The coupling components 1822 may take the form of any of the embodiments discussed above with reference to the coupling components 1816, and the integrated circuit component 1824 may take the form of any of the embodiments discussed above with reference to the integrated circuit component 1820.

The integrated circuit device assembly 1800 illustrated in FIG. 18 further includes a package-on-package structure 1834 coupled to the second face 1842 of the circuit board 1802 by coupling components 1828. The package-on-package structure 1834 may include an integrated circuit component 1826 and an integrated circuit component 1832 coupled together by coupling components 1830 such that the integrated circuit component 1826 is disposed between the circuit board 1802 and the integrated circuit component 1832. The coupling components 1828 and 1830 may take the form of any of the embodiments of the coupling components 1816 discussed above, and the integrated circuit components 1826 and 1832 may take the form of any of the embodiments of the integrated circuit component 1820 discussed above. The package-on-package structure 1834 may be configured in accordance with any of the package-on-package structures known in the art.

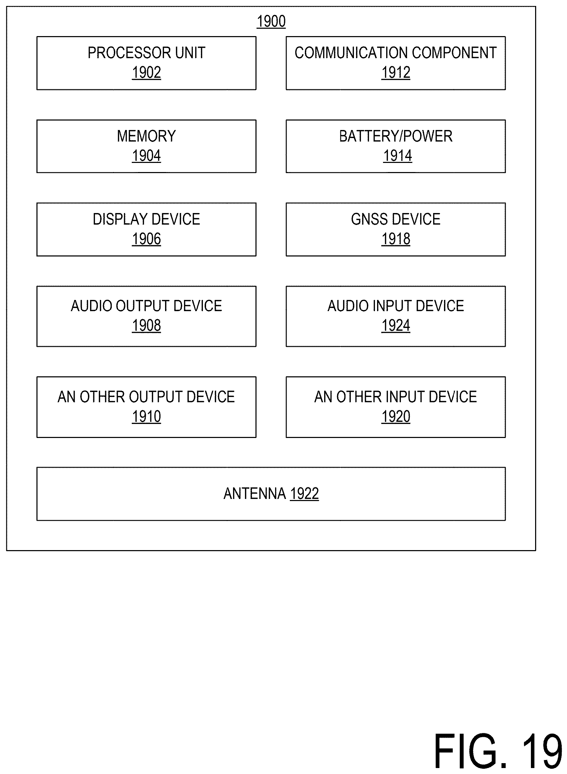

FIG. 19 is a block diagram of an example electrical device 1900 that is to be subjected to active liquid immersion cooling and that may include any of the microelectronic assemblies disclosed herein. For example, any suitable ones of the components of the electrical device 1900 may include one or more of the integrated circuit device assembly 1800, integrated circuit component 1820, or integrated circuit structure 1700 disclosed herein. A number of components are illustrated in FIG. 19 as included in the electrical device 1900, but any one or more of these components may be omitted or duplicated, as suitable for the application. In some embodiments, some or all of the components included in the electrical device 1900 may be attached to one or more motherboards mainboards, or system boards. In some embodiments, one or more of these components are fabricated onto a single system-on-a-chip (SoC) die.

Additionally, in various embodiments, the electrical device 1900 may not include one or more of the components illustrated in FIG. 19, but the electrical device 1900 may include interface circuitry for coupling to the one or more components. For example, the electrical device 1900 may not include a display device 1906, but may include display device interface circuitry (e.g., a connector and driver circuitry) to which a display device 1906 may be coupled. In another set of examples, the electrical device 1900 may not include an audio input device 1924 or an audio output device 1908, but may include audio input or output device interface circuitry (e.g., connectors and supporting circuitry) to which an audio input device 1924 or audio output device 1908 may be coupled.

The electrical device 1900 may include one or more processor units 1902. As used herein, the terms "processor unit," "processing unit," or "processor" may refer to any device or portion of a device that processes electronic data from registers and/or memory to transform that electronic data into other electronic data that may be stored in registers and/or memory. The one or more processor units 1902 may include one or more digital signal processors (DSPs), application-specific integrated circuits (ASICs), central processing units (CPUs), graphics processing units (GPUs), general-purpose GPUs (GPGPUs), accelerated processing units (APUs), field-programmable gate arrays (FPGAs), neural network processing units (NPUs), data processor units (DPUs), accelerators (e.g., graphics accelerator, compression accelerator, artificial intelligence accelerator), controller cryptoprocessors (specialized processors that execute cryptographic algorithms within hardware), server processors, controllers, or any other suitable type of processor units. As such, the processor unit can be referred to as an XPU (or xPU).

The electrical device 1900 may include a memory 1904, which may itself include one or more memory devices such as volatile memory (e.g., dynamic random access memory (DRAM), static random-access memory (SRAM)), non-volatile memory (e.g., read-only memory (ROM), flash memory, chalcogenide-based phase-change non-voltage memories), solid state memory, and/or a hard drive. In some embodiments, the memory 1904 may include memory that is located on the same integrated circuit die as the one or more processor units 1902. This memory may be used as cache memory (e.g., Level 1 (L1), Level 2 (L2), Level 3 (L3), Level 4 (L4), Last Level Cache (LLC)) and may include embedded dynamic random-access memory (eDRAM) or spin transfer torque magnetic random-access memory (STT-MRAM).

In some embodiments of the electrical device 1900, a first one of the one or more processor units 1902 can be heterogeneous or asymmetric to a second one of the one or more processor units 1902 in the electrical device 1900. There can be a variety of differences between the one or more processor units 1902 in a system in terms of a spectrum of metrics of merit including architectural, microarchitectural, thermal, power consumption characteristics, and the like. These differences can effectively manifest themselves as asymmetry and heterogeneity among the one or more processor units 1902 in the electrical device 1900.

In some embodiments, the electrical device 1900 may include a communication component 1912. For example, the communication component 1912 can manage wireless communications for the transfer of data to and from the electrical device 1900. The term "wireless" and its derivatives may be used to describe circuits, devices, systems, methods, techniques, communications channels, etc., that may communicate data through the use of modulated electromagnetic radiation through a nonsolid medium. The term "wireless" does not imply that the associated devices do not contain any wires, although in some embodiments they might not.

The communication component 1912 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication component 1912 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication component 1912 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication component 1912 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication component 1912 may operate in accordance with other wireless protocols in other embodiments. The electrical device 1900 may include an antenna 1922 to facilitate wireless communications and/or to receive other wireless communications (such as AM or FM radio transmissions).

In some embodiments, the communication component 1912 may manage wired communications, such as electrical, optical, or any other suitable communication protocols (e.g., IEEE 802.3 Ethernet standards). In some embodiments, the electrical device 1900 comprises multiple communication components. For instance, a first communication component may be dedicated to shorter-range wireless communications such as Wi-Fi or Bluetooth, and a second communication component may be dedicated to longer-range wireless communications such as global positioning system (GPS), EDGE, GPRS, CDMA, WiMAX, LTE, EV-DO, or others. In some embodiments, a first communication component may be dedicated to wireless communications, and a second communication component may be dedicated to wired communications.

The electrical device 1900 may include battery/power circuitry 1914. The battery/power circuitry 1914 may include one or more energy storage devices (e.g., batteries or capacitors) and/or circuitry for coupling components of the electrical device 1900 to an energy source separate from the electrical device 1900 (e.g., AC line power).

The electrical device 1900 may include a display device 1906 (or corresponding interface circuitry, as discussed above). The display device 1906 may include one or more embedded or wired or wirelessly connected external visual indicators, such as a heads-up display, a computer monitor, a projector, a touchscreen display, a liquid crystal display (LCD), a light-emitting diode display, or a flat panel display.

The electrical device 1900 may include an audio output device 1908 (or corresponding interface circuitry, as discussed above). The audio output device 1908 may include any embedded or wired or wirelessly connected external device that generates an audible indicator, such as speakers, headsets, or earbuds.

The electrical device 1900 may include an audio input device 1924 (or corresponding interface circuitry, as discussed above). The audio input device 1924 may include any embedded or wired or wirelessly connected device that generates a signal representative of a sound, such as microphones, microphone arrays, or digital instruments (e.g., instruments having a musical instrument digital interface (MIDI) output). The electrical device 1900 may include a Global Navigation Satellite System device (GNSS) (or corresponding interface circuitry, as discussed above), such as a Global Positioning System (GPS) device. The GNSS device 1918 may be in communication with a satellite-based system and may determine a geolocation of the electrical device 1900 based on information received from one or more GNSS satellites, as known in the art.

The electrical device 1900 may include another output device 1910 (or corresponding interface circuitry, as discussed above). Examples of the other output device 1910 may include an audio codec, a video codec, a printer, a wired or wireless transmitter for providing information to other devices, or an additional storage device.

The electrical device 1900 may include another input device 1920 (or corresponding interface circuitry, as discussed above). Examples of the other input device 1920 may include an accelerometer, a gyroscope, a compass, an image capture device (e.g., monoscopic or stereoscopic camera), a trackball, a trackpad, a touchpad, a keyboard, a cursor control device such as a mouse, a stylus, a touchscreen, proximity sensor, microphone, a bar code reader, a Quick Response (QR) code reader, electrocardiogram (ECG) sensor, PPG (photoplethysmogram) sensor, galvanic skin response sensor, any other sensor, or a radio frequency identification (RFID) reader.

The electrical device 1900 may have any form factor, such as a hand-held or mobile electrical device (e.g., a cell phone, a smartphone, a mobile internet device, a music player, a tablet computer, a laptop computer, a 2-in-1 convertible computer, a portable all-in-one computer, a netbook computer, an ultrabook computer, a personal digital assistant (PDA), an ultra-mobile personal computer, a portable gaming console), a desktop electrical device, a server, a rack-level computing solution (e.g., blade, tray, or sled computing system), a workstation or other networked computing component, a printer, a scanner, a monitor, a set-top box, an entertainment control unit, a stationary gaming console, smart television, a vehicle control unit, a digital camera, a digital video recorder, a wearable electrical device or an embedded computing system (e.g., computing systems that are part of a vehicle, smart home appliance, consumer electronics product or equipment, manufacturing equipment). In some embodiments, the electrical device 1900 may be any other electronic device that processes data. In some embodiments, the electrical device 1900 may comprise multiple discrete physical components. Given the range of devices that the electrical device 1900 can be manifested as in various embodiments, in some embodiments, the electrical device 1900 can be referred to as a computing device or a computing system.

As used in this application and the claims, a list of items joined by the term "and/or" can mean any combination of the listed items. For example, the phrase "A, B and/or C" can mean A; B; C; A and B; A and C; B and C; or A, B and C. As used in this application and the claims, a list of items joined by the term "at least one of" can mean any combination of the listed terms. For example, the phrase "at least one of A, B or C" can mean A; B; C; A and B; A and C; B and C; or A, B, and C. Moreover, as used in this application and the claims, a list of items joined by the term "one or more of" can mean any combination of the listed terms. For example, the phrase "one or more of A, B and C" can mean A; B; C; A and B; A and C; B and C; or A, B, and C.

As used in this application and the claims, the phrase "individual of" or "respective of" following by a list of items recited or stated as having a trait, feature, etc. means that all the items in the list possess the stated or recited trait, feature, etc. For example, the phrase "individual of A, B, or C, comprise a sidewall" or "respective of A, B, or C, comprise a sidewall" means that A comprises a sidewall, B comprises sidewall, and C comprises a sidewall.

The disclosed methods, apparatuses, and systems are not to be construed as limiting in any way. Instead, the present disclosure is directed toward all novel and nonobvious features and aspects of the various disclosed embodiments, alone and in various combinations and subcombinations with one another. The disclosed methods, apparatuses, and systems are not limited to any specific aspect or feature or combination thereof, nor do the disclosed embodiments require that any one or more specific advantages be present or problems be solved.

Theories of operation, scientific principles, or other theoretical descriptions presented herein in reference to the apparatuses or methods of this disclosure have been provided for the purposes of better understanding and are not intended to be limiting in scope. The apparatuses and methods in the appended claims are not limited to those apparatuses and methods that function in the manner described by such theories of operation.

Although the operations of some of the disclosed methods are described in a particular, sequential order for convenient presentation, it is to be understood that this manner of description encompasses rearrangement, unless a particular ordering is required by specific language set forth herein. For example, operations described sequentially may in some cases be rearranged or performed concurrently. Moreover, for the sake of simplicity, the attached figures may not show the various ways in which the disclosed methods can be used in conjunction with other methods.

The following examples pertain to additional embodiments of technologies disclosed herein.

Example 1 is a cold plate assembly comprising: a base plate comprising a surface; and a plurality of fins attached to the surface of the base plate, wherein the plurality of fins are arranged substantially in parallel, wherein individual fins of the plurality of fins have an opening, wherein the openings of the plurality of fins define a channel that extends through the plurality of fins, and wherein the channel is continuous, substantially straight, and extends in a first direction that is substantially orthogonal to a second direction along which the individual fins in the plurality of fins extend lengthwise, and wherein the channel is tubeless.

Example 2 comprises the cold plate assembly of example 1, wherein the channel is further defined by a groove in the surface of the base plate.

Example 3 comprises the cold plate assembly of any one of examples 1-2, wherein the openings are cutouts in the plurality of fins, the cutouts located where the plurality of fins meets the surface of the base plate.

Example 4 comprises the cold plate assembly of any one of examples 1-3, wherein the channel is substantially parallel to the surface of the base plate.

Example 5 comprises the cold plate assembly of any one of examples 1-4, wherein for individual fins of the plurality of fins, the opening for the individual fin is substantially centered along a length of the individual fin.

Example 6 comprises the cold plate assembly of any one of examples 1-5, further comprising a cover attached to a top of one or more fins of the plurality of fins.

Example 7 comprises the cold plate assembly of any one of examples 1-6 wherein the channel is closed-ended.

Example 8 is a cold plate assembly comprising: a base plate comprising a surface; a plurality of fins attached to the surface of the base plate, wherein the plurality of fins are arranged substantially in parallel, wherein individual fins of the plurality of fins have an opening, wherein the openings of the plurality of fins define a first channel that extends through the plurality of fins, and wherein the first channel is continuous, substantially straight, and extends in a first direction that is substantially orthogonal to a second direction along which the individual fins in the plurality of fins extend lengthwise, wherein the plurality of fins define a plurality of second channels located between adjacent fins, and wherein the first channel is located closer to the base plate than tops of the plurality of fins; and a tube extending through at least a portion of the first channel, wherein the tube comprises one or more openings on a side of the tube, individual of the one or more openings at least partially overlapping with at least one second channel of the plurality of second channels located between adjacent fins.

Example 9 comprises the cold plate assembly of example 8, wherein the tube extends through the entirety of the first channel.

Example 10 comprises the cold plate assembly of any one of examples 8-9, wherein bottoms of the openings of the plurality of fins are substantially flush with the surface of the base plate.

Example 11 comprises the cold plate assembly of any one of examples 8-10, wherein the first channel is further defined by a groove in the surface of the base plate.

Example 12 comprises the cold plate assembly of any one of examples 8-11, wherein the openings are cutouts in the plurality of fins, the cutouts located where the plurality of fins meets the surface of the base plate.

Example 13 comprises the cold plate assembly of any one of examples 8-12, wherein the first channel is substantially parallel to the surface of the base plate.

Example 14 comprises the cold plate assembly of any one of examples 8-13, wherein for individual fins of the plurality of fins, the opening for the individual fin is substantially centered along a length of the individual fin.

Example 15 comprises the cold plate assembly of any one of examples 8-14, further comprising a cover attached to a top of one or more fins of the plurality of fins.

Example 16 comprises the cold plate assembly of any one of examples 8-15, wherein the first channel is closed-ended.

Example 17 is a system comprising: a cold plate assembly comprising: a base plate comprising a surface; and a plurality of fins attached to the surface of the base plate, wherein the plurality of fins are arranged substantially in parallel, wherein individual fins of the plurality of fins have an opening, wherein the openings of the plurality of fins define a channel that extends through the plurality of fins, and wherein the channel is continuous, substantially straight, and extends in a first direction that is substantially orthogonal to a second direction along which the individual fins in the plurality of fins extend lengthwise, wherein the plurality of fins define a plurality of channels located between the plurality of fins, and wherein the channel is tubeless; and an integrated circuit component attached to a bottom of the cold plate assembly.

Example 18 comprises the system of example 17, wherein bottoms of the openings of the plurality of fins are substantially flush with the surface of the base plate.

Example 19 comprises the system of any one of examples 17-18, wherein the channel is further defined by a groove in the surface of the base plate.

Example 20 comprises the system of any one of examples 17-19, wherein the openings are cutouts in the plurality of fins, the cutouts located where the plurality of fins meets the surface of the base plate.

Example 21 comprises the system of any one of examples 17-20, wherein the channel is substantially parallel to the surface of the base plate.

Example 22 comprises the system of any one of examples 17-21, wherein for individual fins of the plurality of fins, the opening for the individual fin is substantially centered along a length of the individual fin.

Example 23 comprises the system of any one of examples 17-22 wherein the channel is closed-ended.

Example 24 comprises the system of any one of examples 17-23, further comprising an immersion tank, the cold plate assembly and the integrated circuit component located within the immersion tank and submerged in coolant.

Example 25 comprises the system of any one of examples 17-24 wherein the cold plate assembly and the integrated circuit component are located within a chassis.

Example 26 is a system comprising: a cold plate assembly comprising: a base plate comprising a surface; a plurality of fins attached to the surface of the base plate, wherein the plurality of fins are arranged substantially in parallel, wherein individual fins of the plurality of fins have an opening, wherein the openings of the plurality of fins define a first channel that extends through the plurality of fins, and wherein the first channel is continuous, substantially straight, and extends in a first direction that is substantially orthogonal to a second direction along which the individual fins in the plurality of fins extend lengthwise, wherein the plurality of fins define a plurality of second channels located between adjacent fins, and wherein the first channel is located closer to the base plate than tops of the plurality of fins; and a tube extending through at least a portion of the first channel, wherein the tube comprises one or more openings on a side of the tube, individual of the one or more openings at least partially overlapping with at least one second channel of the plurality of second channels located between adjacent fins; and an integrated circuit component attached to a bottom of the cold plate assembly.

Example 27 comprises the system of example 26, wherein the tube extends through the entirety of the first channel.

Example 28 comprises the system of example 26 or 27, wherein one end of the tube is closed.

Example 29 comprises the system of any one of examples 26-28, wherein bottoms of the openings of the plurality of fins are substantially flush with the surface of the base plate.

Example 30 comprises the system of any one of examples 26-29, wherein the first channel is further defined by a groove in the surface of the base plate.

Example 31 comprises the system of any one of examples 26-30, wherein the openings are cutouts in the plurality of fins, the cutouts located where the plurality of fins meets the surface of the base plate.

Example 32 comprises the system of any one of examples 26-31, wherein the first channel is substantially parallel to the surface of the base plate.

Example 33 comprises the system of any one of examples 26-32, wherein for individual fins of the plurality of fins, the opening for the individual fin is substantially centered along a length of the individual fin.

Example 34 comprises the system of any one of examples 26-33 wherein the first channel is closed-ended.

Example 35 comprises the system of any one of examples 26-34, further comprising an immersion tank, the cold plate assembly and the integrated circuit component located within the immersion tank and submerged in coolant.

Example 36 comprises the system of any one of examples 26-35, wherein the cold plate assembly and the integrated circuit component are located within a chassis.

Example 37 is a method comprising: causing an integrated circuit component to execute instructions; and pumping coolant through a cold plate assembly attached to the integrated circuit component, the cold plate assembly comprising: a base plate comprising a surface; and a plurality of fins attached to the surface of the base plate, wherein the plurality of fins are arranged substantially in parallel, wherein individual fins of the plurality of fins have an opening, wherein the openings of the plurality of fins define a channel that extends through the plurality of fins, and wherein the channel is continuous, substantially straight, and extends in a first direction that is substantially orthogonal to a second direction along which the individual fins in the plurality of fins extend lengthwise, and wherein the channel is tubeless.

Example 38 comprises the method of example 37, wherein bottoms of the openings of the plurality of fins are substantially flush with the surface of the base plate.

Example 39 comprises the method of any one of examples 37-38, wherein the channel is further defined by a groove in the surface of the base plate.

Example 40 comprises the method of any one of examples 37-39, wherein the openings are cutouts in the plurality of fins, the cutouts located where the plurality of fins meets the surface of the base plate.

Example 41 comprises the method of any one of examples 37-40, wherein the channel is substantially parallel to the surface of the base plate.

Example 42 comprises the method of any one of examples 37-41 wherein the channel is closed-ended.

Example 43 is a method comprising: causing an integrated circuit component to execute instructions; and pumping coolant through a cold plate assembly attached to the integrated circuit component, the cold plate assembly comprising: a base plate comprising a surface; a plurality of fins attached to the surface of the base plate, wherein the plurality of fins are arranged substantially in parallel, wherein individual fins of the plurality of fins have an opening, wherein the openings of the plurality of fins define a first channel that extends through the plurality of fins, and wherein the first channel is continuous, substantially straight, and extends in a first direction that is substantially orthogonal to a second direction along which the individual fins in the plurality of fins extend lengthwise, wherein the plurality of fins define a plurality of second channels located between adjacent fins, and wherein the first channel is located closer to the base plate than tops of the plurality of fins; and a tube extending through at least a portion of the first channel, wherein the tube comprises one or more openings on a side of the tube, individual of the one or more openings at least partially overlapping with at least one second channel of the plurality of second channels located between the plurality of fins.

Example 44 comprises the method of example 43, wherein the tube extends through the entirety of the first channel.

Example 45 comprises the method of any one of examples 43-44, wherein bottoms of the openings of the plurality of fins are substantially flush with the surface of the base plate.

Example 46 comprises the method of any one of examples 43-45, wherein the first channel is further defined by a groove in the surface of the base plate.

Example 47 comprises the method of any one of examples 43-46, wherein the openings are cutouts in the plurality of fins, the cutouts located where the plurality of fins meets the surface of the base plate.

Example 48 comprises the method of any one of examples 43-47, wherein the first channel is substantially parallel to the surface of the base plate.

Example 49 comprises the method of any one of examples 43-48 wherein the first channel is closed-ended.

Example 50 is a system comprising: an integrated circuit component; and a cooling means to provide cooling to the integrated circuit component by directing a cooling fluid exiting an inlet tube to first flow in a first direction over the integrated circuit component and to then flow in a second direction over the integrated circuit component, the first direction substantially orthogonal to the second direction.

Example 51 comprises the system of example 50, further comprising an immersion tank, the integrated circuit component and the cooling means located within the immersion tank and submerged in coolant.

## Claims

1. A cold plate assembly comprising:
a base plate comprising a surface; and
a plurality of fins attached to the surface of the base plate, wherein the plurality of fins are arranged substantially in parallel, wherein individual fins of the plurality of fins have an opening, wherein the openings of the plurality of fins define a channel that extends through the plurality of fins, and wherein the channel is continuous, substantially straight, and extends in a first direction that is substantially orthogonal to a second direction along which the individual fins in the plurality of fins extend lengthwise, and wherein the channel is tubeless.

2. The cold plate assembly of claim 1, wherein the channel is further defined by a groove in the surface of the base plate.

3. The cold plate assembly of any one of claims 1-2, wherein the openings are cutouts in the plurality of fins, the cutouts located where the plurality of fins meets the surface of the base plate.

4. The cold plate assembly of any one of claims 1-3, wherein the channel is substantially parallel to the surface of the base plate.

5. The cold plate assembly of any one of claims 1-4, wherein for individual fins of the plurality of fins, the opening for the individual fin is substantially centered along a length of the individual fin.

6. The cold plate assembly of any one of claims 1-5, further comprising a cover attached to a top of one or more fins of the plurality of fins.

7. The cold plate assembly of any one of claims 1-6 wherein the channel is closed-ended.

8. A system comprising:
a cold plate assembly comprising:
a base plate comprising a surface; and
a plurality of fins attached to the surface of the base plate, wherein the plurality of fins are arranged substantially in parallel, wherein individual fins of the plurality of fins have an opening, wherein the openings of the plurality of fins define a channel that extends through the plurality of fins, and wherein the channel is continuous, substantially straight, and extends in a first direction that is substantially orthogonal to a second direction along which the individual fins in the plurality of fins extend lengthwise, wherein the plurality of fins define a plurality of channels located between the plurality of fins, and wherein the channel is tubeless; and
an integrated circuit component attached to a bottom of the cold plate assembly.

9. The system of claim 8, wherein bottoms of the openings of the plurality of fins are substantially flush with the surface of the base plate.

10. The system of any one of claims 8-9, wherein the channel is further defined by a groove in the surface of the base plate.

11. The system of any one of claims 8-10, wherein the openings are cutouts in the plurality of fins, the cutouts located where the plurality of fins meets the surface of the base plate.

12. The system of any one of claims 8-11, wherein the channel is substantially parallel to the surface of the base plate.

13. The system of any one of claims 8-12, wherein for individual fins of the plurality of fins, the opening for the individual fin is substantially centered along a length of the individual fin.

14. The system of any one of claims 8-13, further comprising an immersion tank, the cold plate assembly and the integrated circuit component located within the immersion tank and submerged in coolant.

15. The system of any one of claims 8-13 wherein the cold plate assembly and the integrated circuit component are located within a chassis.
